(19)

Europäisches
Patentamt

European
Patent Office

Office européen
des brevets

(11) **EP 4 203 405 A1**

(12) **EUROPEAN PATENT APPLICATION**

(43) Date of publication:
**28.06.2023 Bulletin 2023/26**

(21) Application number: **21306923.0**

(22) Date of filing: **23.12.2021**

(51) International Patent Classification (IPC):
***H04L 27/26*** (2006.01)          ***H04L 1/08*** (2006.01)
***H04L 5/00*** (2006.01)

(52) Cooperative Patent Classification (CPC):
**H04L 27/2602; H04L 1/00; H04L 1/08**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Eurecom
06410 Biot (FR)**

(72) Inventor: **KNOPP, Raymond
06410 BIOT (FR)**

(74) Representative: **Atout PI Laplace
Immeuble "Visium"
22, avenue Aristide Briand
94117 Arcueil Cedex (FR)**

(54) **DEVICE AND METHOD FOR TRANSMITTING PAYLOAD DATA WITH REPETITIONS OF A CODED WAVEFORM**

(57) There is provided a transmitter device (1) for transmitting a digital input message corresponding to payload data through a communication channel (3), the payload data comprising B1 payload bits, the transmitter device comprising:
- a waveform generator (10) configured to determine a transmission waveform in $N$ dimensions from said $B1$ payload bits, the transmission waveform being represented by a signal vector $s$ comprising $L$ components $s_l(m)$;
- an outer code generator (11) configured to generate an outer code $x_n$ from additional $B2$ bits, the outer code being represented by a vector $x_n$ comprising $N_{reps}$ components;
- a repetition unit (12) configured to spread the information contained in the waveform $s$ across $N_{reps}$ time slots;
- a combining unit (14) configured to combine said waveform $s$ with the outer code sequence $x_n$, which provides a combined signal $x_n s_l$, the components of the outer code $x_n$ modulate the waveform coming from at least a part of a time slot;
the transmitter device being configured to transmit the combined signal in a particular repetition $n$ over the communication channel using the transmit antennas.

**FIGURE 2**

EP 4 203 405 A1

**Description**

**TECHNICAL FIELD**

The invention generally relates to digital communications and in particular to a device and a method for transmitting payload data with repetitions of a coded waveform.

**BACKGROUND**

Mobile communication systems are progressing at an accelerated pace, in order to satisfy increasing demands in terms of real-time services and applications with higher capacities.

Mobile communication systems are rapidly progressing from a 4th generation (4G) mobile communication system to the future 5th generation (5G) mobile communication systems which are being standardized to provide rich, reliable and hyper-connected communications. In particular, 5G New Radio presents significant challenges.

A mobile communication system comprises a transmitter that transmits digital data comprising information symbols to one or more receivers through a transmission channel. The receiver receives and decodes the transmitted signal using a reverse processing as the one implemented at the transmitter. The digital data transmitted by the transmitter can comprise user data bits and control data bits.

The main existing transmission control data formats for 5G NR systems comprise uplink control channels, such as physical uplink control channel (PUCCH) and physical random access channel (PRACH). Control data can also be multiplexed or transmitted exclusively on the physical uplink shared channel (PUSCH). Different transmission formats exist for such control channels such as for example LTE/NR PUCCH formats 0, 1, 2, 3 and 4 considered in current 3GPP systems (LTE stands for "Long Term Evolution").

A significant challenge for improving the transmission of such control channel data is to provide the transmitter with a capacity of transmitting small payloads (around tens of bits) with low probability of error at very low signal-to-noise ratios.

Such challenge can be generally achieved both by optimizing the energy efficiency of the transmit waveform through:

- a minimization of the peak-to-average power ratio (PAPR), and
- a design of strong structured coding strategies permitting low-complexity detection algorithms.

Known solutions to reduce PAPR include peak windowing, scaling, and clipping. However, such approaches generate interference and distortions in the OFDM modulated signal which requires a further filtering to mitigate the interferences and distorsions.

Existing decoding algorithms used at the receivers to decode received signals corresponding to the current control channel formats (such as PUCCH) are based on sub-optimal reduced-complexity approaches. Such approaches consist of least-squares channel estimation based on the DMRS signals (DMRS stands for Demodulation Reference Signal) followed by quasi-coherent detection and soft-combining of repetitions from rate matching. These two operations yield soft-decisions for each of the coded bits. In the case of the RM code for example, a permutation is then applied to the 32 received soft-decisions to recuperate the bi-orthogonal structure of the code which is then amenable to reduced-complexity decoding via a fast Hadamard Transform as described in US8315185B2. For the polar-coded case, the soft-decisions are passed to one of the reduced-complexity polar decoding algorithms as described in Fast List Decoders for Polar Codes by Gabi Sarkis, Pascal Giard, Alexander Vardy, Claude Thibeault, and Warren J. Gross, IEEE Journal on Selected Areas in Communications, VOL. 34, NO. 2, FEBRUARY 2016. In these two existing approaches, the algorithms are sub-optimal as the detection method uses separate channel estimation and quasi-coherent detection. Another possible solution would be to use a fully non-coherent receiver using the DMRS signals. However, such solution involves an increase in complexity, especially for a RM coded case with longer bit lengths.

There is accordingly a need for a transmission device and method that improves waveform transmissions.

**Summary of the invention**

To address these and other problems there is provided A transmitter device for transmitting a digital input message corresponding to payload data through a communication channel, the payload data comprising B1 payload bits, the transmitter device comprising a set of transmit antennas. Advantageously, the transmitter device comprising:

- a waveform generator configured to determine a transmission waveform in $N$ dimensions from the B1 payload bits, the transmission waveform being represented by a signal vector s comprising $L$ components $s_l(m)$ ($l$ = 0, 1,...,$L$),

- an outer code generator configured to generate an outer code $x_n$ ($n$ = 0, 1, ..., $N_{reps}$) from additional $B2$ bits, the outer code being represented by a vector $x_n$ comprising $N_{reps}$ components;
- a repetition unit configured to spread the information contained in the waveform $s$ across $N_{reps}$ time slots;
- a combining unit configured to combine the waveform $s$ with the outer code sequence $x_n$, which provides a combined signal $x_n s_l$, the components of the outer code $x_n$ modulating the waveform coming from at least a part of a time slot.

The transmitter device is configured to transmit the combined signal in a particular repetition $n$ over the communication channel using the transmit antennas.

In one embodiment, the waveform generator may be configured to use a single carrier or multi-carrier modulation providing modulation symbols grouped into resource blocks, each resource block comprising a number of subcarriers and cover one slot in a time frame, each symbol comprising a number of resource elements, with one resource element per frequency subcarrier, each resource element corresponding to a modulation symbol, the waveform comprising the modulation symbols $s_l$.

The payload data may be uplink control data transmitted in a single slot or subframe, a subframe comprising a number of slots, the digital signal $s$ being associated with a vector representing a finite number of modulation symbols $s_l$, $l$ = 0,1,...,$L$ - 1, where $L$ is the number of modulation symbols comprising a slot or subframe or a portion thereof.

Alternatively, the payload data may correspond to downlink control channels.

In another embodiment, the payload data may correspond to traffic data channels and the B2 bits are used to embed control data.

In some embodiments, the $N$ dimensions correspond to $\alpha KL$, where $K$ is the number of physical resource blocks and $L$ is the number of modulation symbols used for the waveform signal.

Advantageously, the number $B1$ of bits conveyed by the waveform signal and the number of $B2$ bits may be chosen to minimize the overall error probability.

In one embodiment, if the number of repetitions is not large compared to the number N of dimensions of the waveform signal, B2 may be inferior to B1.

In some embodiments, the code sequence generator may be configured to generate an outer code sequence $x_n$, $n$ = 0, 1,..., $N_{reps}$ in $N_{reps}$ dimensions which is optimal for non-coherent reception.

The outer code $x_n$, with $n$ = 0, 1, ..., $N_{reps}$ may comprise $2^{B2} \times N_{reps}$ code sequences $x_{m,n}$ with m = 0,1, ....,$2^{B2}$ - 1 and $n$ = 0,1, ..., $N_{reps}$ - 1.

In some embodiments, the code generated by the outer code generator may be such that a metric $\rho(m, m')$ determined from pairwise correlations between transmitted vectors $x_{m,n}$ and $x^*_{m',n}$ is as close as possible to zero for all ($m$, $m'$), with $\rho(m, m')$ being defined by:

$$\rho(m, m') = \left| \sum_{n=0}^{N_{reps}-1} x_{m,n} x^*_{m',n} \right|$$

In one embodiment, the code generated by the outer code generator may be any row or column of a complex or real $N_{reps} \times N_{reps}$ Hadamard matrix.

In some embodiments, if $2^{B2} < N_{reps}$, the outer code generator may be configured to generate the outer code as an orthogonal code.

If $2^{B2} \geq N_{reps}$, the outer code generator may be configured to generate the outer code as a non-coherent code using a generator matrix $G(N_{reps}, B2)$.

In some embodiments, the outer code generator may be configured to determine the non-coherent code as a codeword $\lfloor m2^{-B2} \rfloor$ from a ($B2$, $N_{reps}$) linear error correcting code, having a length B2 and a rank $N_{reps}$.

The outer code generator may be configured to apply a permutation operation to the $B1$ bits prior to generate the outer code.

In one embodiment, the repetition unit may be configured to generate a number $N_{reps}$ of replicas of the waveform signal $s_l(m)$ in time, from at least a part of the waveform signal $s_l(m)$ and the B2 bits of overlay information, the generated replicas $S_r$, with $r$ = 0,1, ... , $N_{reps}$ being transmitted in separate time slots.

The separate time slots may comprise the same number of dimensions as the waveform signal.

In one embodiment, the repetition unit may be configured to previously puncture the waveform signal and generate the replicas from the punctured waveform signal.

The combining unit may be configured to take the $N_{reps}$ replicas $S_r$, and to multiply each dimension of the replicas by a complex scalar corresponding to one component $x_n$, $n = 0, 1, \ldots, N_{reps}$ of the outer code, the $n$-$th$ combined replica being $x_n S_r$.

There is further provided a method for transmitting a digital input message corresponding to payload data through a communication channel, the payload data comprising $B1$ payload bits, the method comprising:

- determining a transmission waveform in $N$ dimensions from the $B1$ payload bits, the transmission waveform being represented by a signal vector $s$ comprising $L$ components $s_l(m)$ ($l = 0, 1, \ldots, L$);
- generating an outer code $x_n$ ($n = 0, 1, \ldots, N_{reps}$) from additional B2 bits, the outer code being represented by a vector $x_n$ comprising $N_{reps}$ components;
- spreading the information contained in the waveform $s$ across $N_{reps}$ time slots;
- combining the waveform $s$ with the outer code sequence $x_n$, which provides a combined signal $x_n s_l$, wherein the components of the outer code $x_n$ modulate the waveform coming from at least a part of a time slot.

The method comprises transmitting the combined signal in a particular repetition $n$ over the communication channel using transmit antennas.

**Brief description of the drawings**

The accompanying drawings, which are incorporated in and constitute a part of this specification, illustrate various embodiments of the invention together with the general description of the invention given above, and the detailed description of the embodiments given below.

Figure 1 schematically represents an exemplary communication system implementing a transmitter according to some embodiments;

Figure 2 is a block diagram representing a transmitter, according to certain embodiments of the invention;

Figure 3 is a block diagram representing a device for generating a non-coherent code;

Figure 4 is a diagram illustrating the performances of embodiments of the invention;

Figure 5 is a flowchart depicting a transmission method, according to some embodiment of the invention.

**Detailed description**

Embodiments of the present invention provide devices and methods for transmitting embedding payloads in a coded waveform.

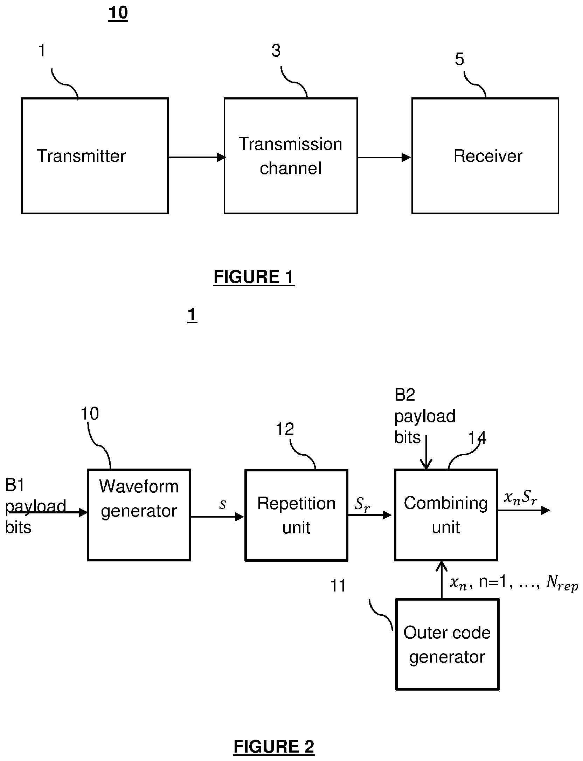

Figure 1 illustrates an exemplary communication system 10 in which embodiments of the invention can be implemented.

The communication system 10 may be for example a wireless communication system. The following description of embodiments of the invention will be made mainly with reference to a wireless communication system for illustration purpose although the skilled person will readily understand that the invention can also apply to other types of communication systems such as a wired system (for example optical fiber communication system).

The communication system 10 may comprise at least one transmitter device 1 (also referred to hereinafter as a "transmitter") configured to transmit a plurality of information symbols to at least one receiver device 5 (hereinafter referred to as "receiver") through a transmission channel 3 (also referred hereinafter to as a "communication channel").

The receiver 5 may be configured to receive the signal transmitted by the transmitter 1 and decode the received signal to recover the original data.

The transmission channel 3 may be any transmission channel adapted to transmit information symbols from the transmitter device 1 to the receiver device 5, depending on the type of the communication system, such as for example a wired connection channel, a wireless medium, an underwater communication channel, etc.

In an application of the invention to wireless communication systems such as ad-hoc wireless networks used in local area communications, wireless sensor networks and radio communication systems (e.g. LTE, LTE-advanced, 5G and beyond), the transmitter 1 and/or the receiver 5 may be any type of fixed or mobile wireless device configured to operate in a wireless environment.

The transmission channel 3 may be any wireless propagation medium adapted to such devices.

The transmitter 1 and/or the receiver 5 may be fixed or mobile and/or may be remotely monitored and/or controlled. The transmitter 1 and/or the receiver 5 may be equipped with power sources that provide power to the different components ensuring the operation of these devices (e.g. dry cell batteries, solar cells, and fuel cells).

The transmission channel 3 may represent any wireless network enabling IoT. Exemplary wireless networks comprise low-power short range networks and LPWANs. Exemplary LPWAN technologies comprise LTE-NB1 and NB-IoT.

Further, the transmission channel 3 may accommodate several pairs of transmitters 1 and receivers 5. In such embodiments, multiple access techniques and/or network coding techniques may be used in combination with error correction codes and modulation. Exemplary multiple access techniques comprise Time Division Multiple Access (TDMA), Frequency Division Multiple Access (FDMA), Code Division Multiple Access (CDMA), and Space Division Multiple Access (SDMA).

The transmission channel 3 may be a noisy channel. For example, the noise may result from the thermal noise of the system components and/or the intercepted interfering radiation by antennas. Other exemplary sources of noise comprise switching, manual interruptions, electrical sparks and lightning. In some embodiments, the total noise may be modeled by an additive white Gaussian noise (AWGN).

The transmission channel 3 may be a multipath channel using single-carrier or multi-carrier modulation formats such as OFDM (Orthogonal Frequency Division Multiplexing) for mitigating frequency-selectivity, interference and delays.

In some embodiments, data transmission in the communication system 10 may correspond to an uplink communication scenario during which the receiver 5 is configured to receive data from one or more transmitters 1 operating in a wireless environment. The receiver 5 may be a base station, a relay station, an eNodeB/gNodeB in a cellular network, an access point in a local area network or in ad-hoc network or any other interfacing device operating in a wireless environment. The transmitter 1 may be, without limitation, a mobile phone, a computer, a laptop, a tablet, a drone, an IoT device etc.

According to some embodiments, the transmitter 1 and/or the receiver 5 may be equipped with a plurality of transmit and/or receive antennas. In such embodiments, space-time coding and/or space-time decoding techniques may be used in combination with coded modulations for encoding data both in the time and space dimensions, thereby exploiting space and time diversities of multiple antennas.

The receiver 5 can be also integrated in the base stations. The receiver 5 may be configured to receive a signal $y_P$ transmitted by the transmitter 2 in a wireless channel. The channel may be noisy (for example channel with Additive White Gaussian Noise (AWGN) subjected to fading). The signal transmitted by the transmitter 1 may be further affected by echoes due to the multiple paths and/or the Doppler effect due to the transmitter and receiver having a non-zero relative velocity.

The transmitter device 1 according to the embodiments of the invention improves the probability of correct detection compared to such existing solutions, even in extreme coverage scenarios which are characterized by low signal-to-noise ratio.

The transmitter 1 is configured to transmit a digital input message $m$ constructed from payload data comprising $B1$ bits and $B2$ additional bits through the communication channel 3. The transmitter device is configured to embed the payload data over repetitions of a coded waveform to enhance coverage. The payload data may be advantageously of short length.

The embodiments of the invention enable adding extra payload for control or traffic information when repetitions are used, whereby the extra payload selects a coded sequence which modulates the original base waveform.

Figure 2 represents a transmitter 1, according to some embodiments.

The transmitter 1 is configured to transmit a digital input message m embedding the $B1$ payload bits and the $B2$ extra data, the $B1$ bits being used to generate a waveform and the $B2$ extra bits being used to generate an outer code used to modulate the generated waveform, component by component, the modulated waveform being sent through repetitions.

Although the invention has particular advantages for uplink control channels, it should be noted that some aspects of the invention may be also applied to downlink control channels.

The input message $m$ is defined as:

$$m = 0, 1, \ldots, 2^B - 1 \quad (1)$$

In Equation (1), $B$ represents the number of channel bits constituting the message m.

The signal received at the receiver 5 may be written as:

$$y_p = \mathrm{H}_p s(m) + z_p \quad (2)$$

In equation (2), $y_p$ represents the received signal vector in $N$ complex dimensions received on a receiver antenna port *p*, s(*m*) designates the *N*-dimensional modulated vector transporting the *B* channel bits corresponding to the message m*,* and $z_p$ represents the additive white Gaussian noise having real and imaginary components being independent and have variance $\sigma^2$ in each dimension. Further, the channel matrix H$_p$ is a $N \times N$ complex diagonal designating the complex value of the channel matrix representing the communication channel. The channel matrix H$_p$ has arbitrary components unknown to the receiver 5.

In some embodiment, the modulated signal may satisfy ||s(*m*)|| = *c* ∀*m*, where c is an arbitrary constant.

In some embodiments, such as in the 3GPP 5G NR systems, the components of the modulated signal s(*m*) and the received signal $y_p$ may represent samples in frequency and time.

The various embodiments of the invention provide a transmitter device 1 and a transmission method capable of embedding payload data over repetitions of a coded waveform *s* from payload data comprising *B*2 bits and additional *B*1 bits, such that the transmitted message *m* is given by:

$$ m = B1 + B2 \quad (3) $$

Advantageously, the transmitter 1 comprises:

- a waveform generator 10 configured to determine a transmission waveform *s* in *N* dimensions from the *B*1 payload bits; the transmission waveform is represented by a waveform vector *s* comprising *L* components $s_l(m)$ (*l* = 0, 1,..., *L*);
- an outer code generator 11 configured to generate an outer code $x_n$ with *n* = 0, 1, ..., $N_{reps}$ from the additional *B*2 bits, the outer code being represented by a vector $x_n$ comprising $N_{reps}$ components;
- a repetition unit 12 configured to spread the information contained in the waveform $s_l(m)$ across $N_{reps}$ time slots;
- a combining unit 14 configured to combine said each waveform component $s_l(m)$ with an outer code component $x_n$, which provides a combined signal $x_n s_l$ (also called 'coded waveform').

The components of the outer code component $x_n$ modulates the digital signal $s_l(m)$ coming from at least a part of a time slot. In some embodiments, the components of the outer code component $x_n$ modulates the waveform component $s_l(m)$ coming from the entire time slot. Alternatively, for example in embodiments using frequency-hopping, the components of the outer code $x_n$ modulate the digital signal $s_l(m)$ coming from only a part of the time slot, which provides a combined signal s.

The transmitter device 1 is configured to transmit the combined coded waveform in a particular repetition *n* over the communication channel 3 using the transmit antennas.

The waveform generator 10 may be arbitrary waveform generator that takes the *B*1 bits to generate a waveform *S* in *N* dimensions. For example, a transmission waveform may be represents the OFDM symbols of a 3GPP slot/subframe conveying $B_1$ bits.

The waveform generated by the waveform generator 10 may be generated using a single carrier or a multi-carrier modulation.

Single carrier or a multi-carrier modulation converts a repetition *n* of the coded waveform *s,* embedding the payload data, from the time domain to the frequency domain using a single carrier or a multi-carrier modulation technique. Exemplary multi-carrier modulation techniques comprise OFDM and FBMC. Signals may be sent from the one or more transmit antennas implemented in the transmitter 1 optionally after filtering, frequency transposition and amplification.

The single carrier or multi-carrier modulation provides a waveform *s* comprising modulation symbols $s_l$, *l* = 0,1,..., *L* - 1 grouped into resource blocks. A resource block comprises a number of subcarriers and covers one slot in a time frame, each symbol comprising a number of resource elements, with one resource element per frequency subcarrier, a resource element corresponding to a modulation symbol.

In some embodiments, the *N* dimensions of the waveform s may correspond to $\alpha KL,$ where *K* is the number of physical resource blocks and *L* is the number of modulation symbols used for the waveform signal, and $\alpha$ is an integer number.

For example, in an 3GPP application of the invention, the integer $\alpha$ is equal to 12 so that the number *N* is given by *N* = 12*KL.* Accordingly, each resource block contains 12 complex dimensions or resource elements over which coding is performed. In such 3GPP application, *K* may be chosen in the range of 1 to 16 for example. Further, the number of symbols *L* may be chosen in the range of 1 to 14 symbols for example, or may be more important if multiple slots are used to signal the *B* bits.

In another application of the invention to single-carrier NB-IoT transmissions, the length N of the linear error correcting code may be given by *N* = 7*L* with *L* designating the number of time slots used for the transmission.

The transmitter device 1 is configured to transmit the coded waveform in the particular repetition *n* (combined signal modulated with single or multi carrier modulation) over the communication channel 3 using the transmit antennas. A repetition or replica refers to an identical copy of s(*m*) comprising the same number of dimensions. The repetition or replica may occur at a different time instant and potentially in a different portion of the frequency spectrum. The channel in time and frequency is assumed to be quasi-invariant across repetitions so that they are subject to the same channel impairments.

The use of repetitions enables transmitting consecutive replicas without waiting for feedback prior to transmitting the next one, which enable enhancing the reliability.

In one embodiment, the payload data *B*1 may be uplink control data transmitted in a single time slot or subframe (a subframe comprises a number of slots). For example, the uplink control data may be PUCCH ('Physical Uplink Control Channels'), the control portion of PUSCH (Physical Uplink Shared Channel) and PRACH (Physical Random Access Channel) (for example as used in 3GPP NR or LTE communication systems). Considering for example, a transmission of PUCCH data, several PUCCH transmission formats in 5G NR can be used such as LTE/NR PUCCH format 2 or LTE/NR PUCCH formats 3 and 4 considered in current 3GPP systems.

In such embodiments, the waveform signal *s* is associated with a vector representing a finite number of modulation symbols $s_l$, $l = 0, 1, ... , L - 1$, where *L* is the number of modulation symbols comprising a slot or subframe or a portion thereof (mini-slot).

In some embodiments, the waveform *s* may use dedicated dimensions for training or Demodulation Reference Symbols (DMRS).

In an exemplary application of the invention, the transmission waveform *s* may therefore represent any 3GPP physical channel waveform, such as PUCCH or PUSCH.

The transmission waveform *s* may comprise DMRS symbols or be transmitted without DMRS.

In some embodiments the *B*1 payload data may alternatively correspond to downlink control channels such as the PDCCH.

In another embodiment, the *B*1 payload data may correspond to traffic data channels such as PDSCH or PUSCH and the *B*2 bits may be used to embed control data.

If a total of *B* bits is to be transmitted, the number *B*1 of bits conveyed by the waveform signal and the number of *B*2 bits using repetitions may be chosen to minimize the overall error probability.

The overall error probability refers to the average number of errors divided by the number of trials. For instance, if on average, there is one error in hundred consecutive transmissions, the error probability may be equal to 1% or $10^{-2}$.

The invention may be used in 3GPP systems, in LTE for NB-IoT or LTE-M systems to improve coverage for low bit-rate applications, or in Rel-17 and future 3GPP systems to enhance coverage or to embed extra control information at negligible cost.

The embodiments of the invention allow for adding extra payload for control information when repetitions are used, whereby the extra payload selects a coded sequence $x_n$, $n = 0, 1, ... , N_{reps} - 1$ which modulates the original base waveform.

In the exemplary case of a PUCCH-type transmission, this will either augment the payload size of the PUCCH transmission or allow for aggregation of multiple CSI/HARQ/RI reports in a common message with potentially different levels of error protection. For PUSCH, it may be used to embed control data more efficiently than the current Rel-15 waveform. For PRACH formats using repetitions, it may be used to embed extra control data for protocol enhancements.

The waveform s is passed to the repetition unit 12 which spreads the information across $N_{reps}$ slots.

The invention may be used for example in 3GPP systems, in LTE for NB-IoT or LTE-M systems to improve coverage for low bit-rate applications, or in Rel-17 systems to enhance coverage.

The waveform s is passed to the repetition unit 12 which spreads the information across $N_{reps}$ slots.

In some embodiments, if the number of repetitions is not large compared to the number N of dimensions of the waveform signal, *B*2 may be inferior to *B*1 (B2 < B1).

For example with the 3GPP PUCCH format 3 waveform, the number of dimensions is typically 168, at least 48 and at most 2520. This may transport *B*1 bits ranging from 3 to several hundred bits, but usually less than 22. For a small number of repetitions, B2 may be on the order of 1-8.

The signal code, $x_n$, $n = 0, 1, ... , N_{reps} - 1$ may have a constant amplitude sequence (for example QAM modulated). The components of the signal code $x_n$, $n = 0, 1, ... , N_{reps} - 1$ modulate the waveform coming from an entire slot or partial slot in the case of frequency-hopping, and the signal $x_n s_l$ is transmitted in a particular repetition *n*. In the case of frequency-hopping within a slot, two sequences derived from the same overlay data may be used to allow for non-coherent combining across hops.

In one embodiment, the repetition unit is configured to choose $x_n = c$, $n = 0, 1, ..., N_{reps} - 1$ where *c* is an arbitrary constant.

In some embodiments, the code sequence generator 12 is configured to generate an outer code sequence $x_n$ ($n = 0, 1, ..., N_{reps}$) in $N_{reps}$ dimensions which is optimal for non-coherent reception.

In one embodiment, the outer code $x_n$, with $n = 0, 1, ..., N_{reps}$ may comprise $2^{B_2} \times N_{reps}$ code sequences $x_{m,n}$ with $m = 0, 1, ..., 2^{B_2} - 1$ and $n = 0, 1, ..., N_{reps} - 1$.

In some embodiment, the outer code may be determined as a non-coherent code using a generator matrix

$G(N_{reps}, B2)$.

In such embodiments, the outer code $x_n$, $n = 0, 1, ..., N_{reps}$ may be determined from a linear error correcting code for joint estimation-detection based on a non-coherent detection metric. In particular, the outer code generator 11 may determine the non-coherent code as a codeword $\lfloor m2^{-B2} \rfloor$ from a $(B2, N_{reps})$ linear error correcting code, having a length B2 and a rank $N_{reps}$.

In such embodiments, the code $x_n$, $n = 0,1,..., N_{reps}$ generated by the outer code generator 11 may be such that a non-coherent detection metric $\rho(m, m')$ determined from pairwise correlations between transmitted vectors $x_{m,n}$ and $x^*_{m',n}$ is small for all $(m,m')$ (that is as close to zero as possible, for all $(m, m')$) with $\rho(m, m')$ being defined by:

$$\rho(m,m') = \left| \sum_{n=0}^{N_{reps}-1} x_{m,n} x^*_{m',n} \right| \quad (4)$$

The quality of the coding scheme may be evaluated and quantified using a parameter, referred to as a loss factor, and given by:

$$LF\big(C(B,N)\big) = 1 - \rho_{NC,max} \quad\quad (5)$$

The loss factor quantifies the loss in effective signal energy compared to an orthogonal signal set. In equation (5), $\rho_{NC,max}$ designates the maximum non-coherent metric associated with the outer code $x_n$ and is given by:

$$\rho_{NC,max} = \max_{m \neq m'} |\rho(m, m')| \quad (6)$$

The performance of the receiver 5 may be asymptotically approximated as:

$$\Pr(\widehat{m} \neq m | A) \cong N_{min} Q\left( \sqrt{\frac{A^2(1-\rho_{NC,max})}{2\sigma^2}} \right) \quad (7)$$

In equation (7), $N_{min}$ designates the average number of the nearest neighbours or $2^{-B} \sum_{m,m'}$, $In(|\rho(m, m')| = \rho_{NC,max})$, where $In(.)$ is the indicator function.

This enable determining a power code adapted for low-to-medium spectral efficiency transmissions, approaching the performance of orthogonal codes, while keeping a practical decoding complexity at the receiver 5.

In some embodiments, if the condition $2^{B2} < N_{reps}$ (condition related to the B2 with respect to a threshold defined by $N_{reps}$) is satisfied, the outer code generator 11 is configured to generate the outer code as an orthogonal code.

In particular, the code generated by the outer code generator 11 may be any row or column of a complex or real $N_{reps} \times N_{reps}$ Hadamard matrix, for higher dimensionality and increased payload size.

Alternatively, if $2^{B2} \geq N_{reps}$, the outer code generator 11 is configured to generate said outer code by applying a code construction and search procedure to generate appropriate outer code sequences with minimal absolute correlation properties.

In some embodiments, the repetitions of the $x_n$ may use different redundancy versions, for example in the case of PUSCH transmissions. In some embodiments, this may be achieved using a permutation operation to permute the $B_1$ bits for each repetition prior to generate the outer code (for example, permutation of at least some of the B1 bits two by two), for example for PUCCH transmission.

In one embodiment, the M-ary block code generator 111 may be configured to determine the non-coherent code $c_n$ as a codeword $\lfloor m2^{-B'} \rfloor$ from a $(B', K)$ linear error correcting code, having a length $B'$ and a rank $K$ represented by a generator matrix $G(B', K)$ given in a systematic form:

$$G(B',K) = \begin{pmatrix} I_K & G_{K \times (B')-K} \end{pmatrix} \quad (8)$$

In equations (8), $I_K$ designates the identity matrix of dimensions $K{\times}K$, $G_{K{\times}B'-K}$ designates a rectangular matrix comprising $K$ lines or row vectors and $BV - \alpha K$ columns or column vectors, and $G_{L{\times}BH-L}$ each designates a rectangular matrix comprising $L$ lines or row vectors and $B' - K$ columns or column vectors. The linear error correcting code may be generated for example as described in EP application N°20305929.0.

EP N°20305929.0 describes a device that can be used to determine such linear error correcting code.

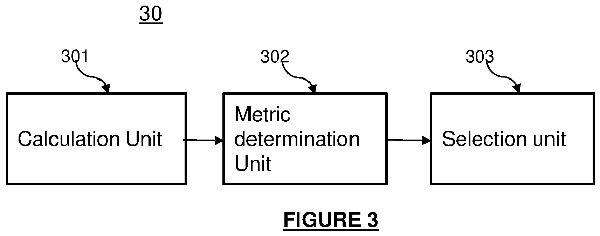

Figure 3 illustrates the generation the linear error correcting code according to EP N°20305929.0.

As shown in figure 3, the device 30 for determining the linear error correcting code comprises:

- a calculation unit 301 configured to determine two or more candidate generator matrices, each candidate generator matrix defining a linear error correcting code and comprising values selected from a predefined set of values, each candidate generator matrix providing a set of codeword vectors from input vectors, the input vectors comprising values selected from the predefined set of values;
- a metric determination unit 302 configured to associate a vector metric to each pair of codeword vectors provided by each candidate generator matrix for a predefined modulation scheme and to associate a matrix metric to each candidate generator matrix, a matrix metric associated with a candidate generator matrix being the minimum value among the vector metrics associated with the pairs of codeword vectors provided by the candidate generator matrix;
- a selection unit 303 configured to select the one or more candidate generator matrices that are associated with the highest matrix metric among the two or more candidate generator matrices.

The linear error correcting code generated is represented by the selected one or more candidate generator matrices.

The selection unit 303 is configured to select, among the one or more candidate generator matrices associated with the highest matrix metric, the candidate generator matrix that is associated with the highest matrix metric and that provides a minimum number of pairs of codeword vectors that are associated with a vector metric equal to the highest matrix metric, these pairs of codeword vectors comprising a zero-valued codeword vector and a non-zero valued codeword vector.

The calculation unit 301 may be configured to previously determine a first set of candidate generator matrices comprising two or more candidate generator matrices and to determine at least one candidate generator matrix from the first set of candidate generator matrices.

The calculation unit 301 may be configured to determine extended codeword vectors from the codeword vectors provided by the selected one or more candidate generator matrices using a code extension by applying a complex or a real Hadamard matrix of one or more codes.

Each pair of codeword vectors may comprise a first codeword vector and a second codeword vector, the calculation unit 301 being configured to determine a first value by mapping the first codeword vector using the predefined modulation scheme and to determine the second value by mapping the second candidate vector using the predefined modulation scheme, the metric determination unit 302 being configured to determine the vector metric associated with each pair of codeword vectors as the absolute value of the pairwise correlation between the first value and the second value.

The linear error correcting code may be M-ary code such as a binary or a quaternary or a 4-ary code.

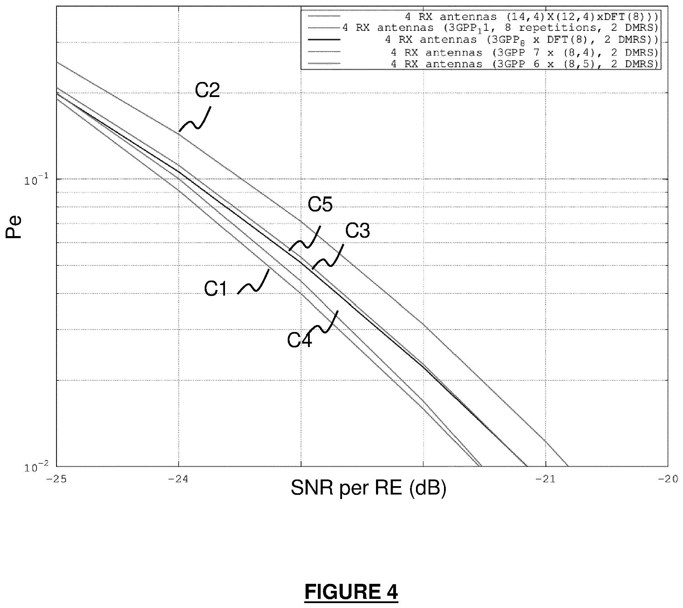

Figure 4 illustrates the steps performed to generate the linear error correcting code in such embodiment.

Turning back to figure 2, in some embodiments, the repetition unit 12 may be configured to generate a number $N_{reps}$ of replicas of the waveform signal $s_l(m)$ in time, from at least a part of the waveform signal $s_l(m)$ and the $B2$ bits of overlay information ($B2$ additional bits). The generated replicas $S_r$, with $r = 0,1, ..., N_{reps}$ may be transmitted in separate time slots. The separate time slots may comprise the same number of dimensions as the waveform signal.

In some embodiments, the repetition unit 12 may be configured to previously puncture the waveform signal and generate the replicas from the punctured waveform signal. Puncturing the waveform s before generating the replicas enable using less dimensions than the dimensions the original waveform by removing a specified number of dimensions whose positions are known to the receiver. A puncturing operation may be applied to the waveform if the waveform s is designed to allow for puncturing. For example, waveforms such as PUCCH, PDCCH, PDSCH, PUSCH which make use of a rate-matching procedure can be punctured in this way.

The repetition unit 12 therefore enable generating replicas of the base waveform in time which allow for a) energy accumulation to improve detectability of the base waveform and b) transmission of the $B2$ bits of overlay information.

The combining unit 14 is configured to take the $N_{reps}$ replicas $S_r$ and to multiply each dimension of the replicas by a complex scalar corresponding to one component $x_n$, $n = 0, 1, ... , N_{reps}$ of the outer code, the $n$ - $th$ combined replica being $x_n S_r$.

The combined signal $x_n S_r$ in the particular repetition $n$ is transmitted on a communication channel whose amplitude and phase characteristics are correlated with the communication channel used for the other repetitions.

The combining unit 14 may be configured to further perform a frequency-hopping operation to each replica corresponding to a repetition $n$ over a frequency bandwidth which consists of numbers of channels to generate a hopping sequence comprising *T* components for said each replica, each replica hopping component corresponding to a frequency hop. The number of frequency hops may be the same for each repetition. The *T* replica hopping components may be transmitted through channel components of the communication channel used for the repetition, the channel component for each frequency hop being correlated with the same channel component in another repetition.

In embodiments where the transmitter 1 and/or the receiver 1 are equipped with a plurality of transmit and/or receive antennas, space-time coding and/or space-time decoding techniques may be used in combination with coded modulations for encoding data both in the time and space dimensions, thereby exploiting space and time diversities of multiple antennas.

It should be noted that the receiver 5 implements a reverse processing of the processing implemented in the transmitter device 1. Accordingly, if a single-carrier modulation is used at the transmitter 1 rather than a multi-carrier modulation, the receiver 5 may implement a single-carrier demodulator. The receiver 5 may further comprise a Space-Time decoder (not illustrated in figure 1) in embodiments in which the receiver 5 is equipped with two or more receive antennas.

The receiver 5 may be configured to receive and decode the signals communicated by the transmitter 1 through the transmission channel 3. In one exemplary embodiment, the receiver 5 may comprise a demodulator (not illustrated in figure 1) configured to generate a demodulated sequence by performing a demodulation of the received signal, and a code decoder (not illustrated in figure 1) configured to deliver as output an estimate of the encoded sequence sent over the transmission channel 3.

Decoding of the *B*1 and *B*2 bits at the receiver can be performed jointly or separately. In embodiments where the *B*1 and *B*2 bits are decoded separately, the original message may be decoded according to the designed coding and modulation scheme including potential DMRS signals since the overlaid sequence is a complex phase sequence. The repetitions may be combined at the level of the log-likelihood ratios after demodulation. Once the *B*1 sequence is detected, the transmit signals may be regenerated and the *B*2 bits may be detected with an optimal non-coherent receiver. If joint detection is used, the overall sequence of *B*1 + *B*2 bits may be detected with a non-coherent (joint estimation detection) receiver.

The receiver 5 may be a coherent receiver configured to determine an estimate $\hat{m}$ of the original message m by solving the optimization problem defined by:

$$\hat{m} = \mathrm{argmax}_m \, \mathrm{Re}(Ae^{-j\theta}ys(m)^H) \qquad (9)$$

Solving the optimization problem in equation (9) may be achieved using a Least-square estimation of the amplitude and phase of the channel using reference signals.

The maximum likelihood detection may be implemented in a joint estimation-detection receiver 5. For complex unknown channel amplitude and phase independent such that the phase $\theta$ is uniformly distributed over $[0, 2\pi]$, the maximum likelihood detection may be expressed by:

$$\hat{m} = \mathrm{argmax}_m \, |ys(m)^H| \qquad (10)$$

In an exemplary implementation of the invention, for 8 repetitions, the outer code may be a (8, *B*2) non-coherent code with repetitions generated with a generator matrix G(*B*2,8).

The waveform generated by the waveform generator 10 may be any waveform.

Figure 4 shows a diagram representing the error probability obtained as a function of the signal to noise ratio SNR per Resource Element, for an 11-bit scenario where $B_1 + B_2 = 11$ for a PUCCH transmission using the Rel-15 PUCCH format 3 as a base waveform for each repetition, with intra-slot frequency hopping.

In figure 4, all curves correspond to a 4 antenna receiver on a TDL-C simulated channel model and convey B1 + B2 = 11 bits of total payload:

- curve C1 corresponds to 11-bit Concatenation of novel horizontal (14,4) and vertical (12,4) codes *DFT (8) (corresponding to a complex Hadamard extension with DFT(8) representing a complex 8x8 Hadamard matrix). This concatenated code uses a single PRB and 14 symbols (similar to 3GPP configurations described below);
- curve C2 corresponds to 3GPP 5G NR PUCCH format 3, 1 PRB 14 symbols, 11 bits, with 8 repetitions and 2 DMRS;
- curve C3 corresponds to 3GPP 5G NR PUCCH format 3, 1 PRB 14 symbols, 7 bits*(8,4) and 2 DMRS (the outer code is a (8,4) code);
- curve C4 corresponds to 3GPP 5G NR PUCCH format 3, 1 PRB 14 symbols, 6 bits*(8,5) and 2 DMRS (the outer code is a (8,5) code);
- curve C5 corresponds to 3GPP 5G NR PUCCH format 3, 1 PRB 14 symbols, 8 bits * DFT(8) and 2 DMRS.

Figure 4 shows that the simple repetition scheme performs worse than all other alternatives which use non-trivial codes to embed additional control data. In particular, Curves C1 and C4 achieve significant coding gain. These examples show how simple structured codes can be embedded on top of existing coded-modulation instead of using simple repetitions to provide additional coding gain in addition to improving detectability of the data at low signal-to-noise ratios which is the main purpose of introducing repetitions. Simple repetitions and a structured code can be combined, especially in cases of extreme coverage enhancement for IoT services. For instance, in cases where repetition orders, $N_{reps}$ are very high (e.g. $N_{reps}$ = 1024) the basic waveform may be generated by the waveform generator 10 using a structured code for a small number, $N_t$, of transmissions (e.g. $N_t$ = 8 as in these examples). This extended waveform may then be repeated $N_{reps}/N_t$ times. The overall transmission count may remain the same and the coding gain may be that of the initial extension ($N_t$).

In terms of decoding, it should be noting that, in the cases with DMRS (3GPP 5G NR PUCCH format 3), the constituent components $B_i$ can be decoded independently, although for all cases shown here, joint-detection was performed. For these instances, for a PUCCH format 3 type transmission with 2 DMRS (curves C2, C3, C4 and C5), the overlay sequence (B2 bits) can be decoded using the Resources Elements from the DMRS, if the signal-to-noise ratio permits it. In addition, the base code can be decoded by combining across slots, either non-coherently or quasi-coherently since the overlay code element (corresponding to the B2 bits) applies a common phase-shift to all Resources Elements and symbols in the slot (in each hop for the case of frequency-hopping). For decoding the B2 overlay bits, slot frequency-hopping may preferably not be applied although intra-slot frequency hopping is possible. For very long repetitions, a trade-off between time-coherence and coherent combining gain may be implemented. Non-coherent combining may be used beyond the time-coherence period of the channel by repeating the overlay code segments (B2 bits).

As shown in Figure 4, curves C1 and C4 achieve significant coding gain over the basic repetition scheme (C2). Curve C4 shows, in particular, how the embodiments of the invention can provide improvement with minimal change in an existing system since the basic coded-modulation strategy is reused almost fully.

The embodiments of the invention more generally enable embedding short payloads on top of a coded waveform which is repeated in several transmission slots for coverage enhancement.

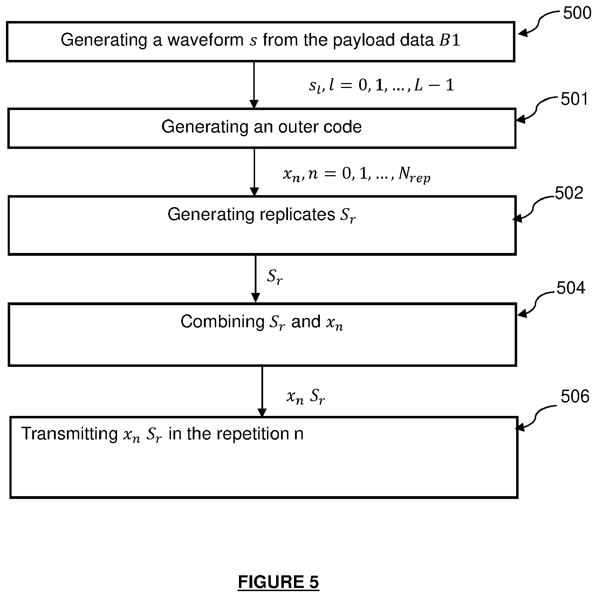

Figure 5 is a flowchart representing a method of for transmitting a digital input message corresponding to payload data through a communication channel 3, the payload data comprising $B$1 payload bits.

In step 500, a transmission waveform $s$ in $N$ dimensions is determined from the $B$1 payload bits, the transmission waveform being represented by a signal vector s comprising $L$ symbols $s_l(m)$ ($l$ = 0, 1, ... , $L$).

In step 502, an outer code $x_n$, $n$ = 0, 1,..., $N_{reps}$ is generated form additional B2 bits, the outer code sequence being represented by a vector $x_n$ comprising $N_{reps}$ components.

In step 504, a number $N_{reps}$ of replicas of the waveform signal s are generated in time, from at least a part of the waveform signal s and the B2 bits of overlay information ($B$2 additional bits). The generated replicas $S_r$, with $r$ = 0,1, ..., $N_{reps}$ may be transmitted in separate time slots. Separate time slots may comprise the same number of dimensions as the waveform signal.

In step 506, the waveform signal s is combined with the outer code sequence $x_n$, which provides a combined signal $x_n s_l$, whereby the components of the outer code $x_n$ modulate the digital signal $s_l(m)$ coming from at least a part of a slot (entire slot or partial slot).

In step 508, the combined signal is transmitted in a particular repetition $n$ over the communication channel using the transmit antennas.

The communication system 10 according to the embodiments of the invention may be used in various applications such as Machine-To-Machine (M2M), Web-of-Things (WoT), and Internet of Things (IoT) (for example vehicle-to-everything V2X communications) involving networks of physical devices, machines, vehicles, home alliances and many other objects connected to each other and provided with a connectivity to the Internet and the ability to collect and exchange data without requiring human-to-human or human-to-computer interactions.

For example, in IoT applications, the communication system 10 may be a wireless network, for example a wireless IoT/M2M network representing low energy power-consumption/long battery life/low-latency/low hardware and operating cost/high connection density constraints such as low-power wide area networks and low-power short-range IoT networks. Exemplary technologies used in such applications may comprise 5G, LTE-NB1 (Long Term Evolution-Machine to Machine, Narrow Band) and NB-IoT (NarrowBand IoT).

The communication system 10 may be used in various consumer, commercial, industrial, and infrastructure applications. Exemplary consumer applications comprise connected vehicles (Internet of Vehicles IoV), home automation/smart home, smart cities, wearable technology, and connected health. Exemplary commercial applications comprise medical and healthcare and transportation. In the medical field, a digitized healthcare system connecting medical resources and healthcare services may be used in which special monitors and sensors are used to enable remote health monitoring and emergency notification. Exemplary industrial applications comprise applications in agriculture, for example in farming using sensors, to collect data on temperature, rainfall, humidity, wind speed, and soil content. Exemplary infrastructure applications may comprise the use of IoT devices to perform monitoring and controlling operations of urban and rural infrastructures such as bridges and railway tracks.

The transmitter 1 and/or the receiver 5 may be any physical internet-enabled device/object provided with required hardware and/or software technologies enabling communication over Internet. The transmitter 1 and/or the receiver 5 may be any standard internet connected-devices such as desktop computers, servers, virtual machines laptops, smart-phones, tablets. In some applications, the transmitter 1 and/or the receiver 5 may be any IoT/M2M device or connected device operating in an IoT/M2M network such as medical devices, temperature and weather monitors, connected cards, thermostats, appliances, security devices, drones, smart clothes, eHealth devices, robots, and smart outlets.

Embodiments of the present invention can take the form of an embodiment containing software only, hardware only or both hardware and software elements.

Furthermore, the methods described herein can be implemented by computer program instructions supplied to the processor of any type of computer to produce a machine with a processor that executes the instructions to implement the functions/acts specified herein. These computer program instructions may also be stored in a computer-readable medium that can direct a computer to function in a particular manner. To that end, the computer program instructions may be loaded onto a computer to cause the performance of a series of operational steps and thereby produce a computer implemented process such that the executed instructions provide processes for implementing the functions specified herein.

It should be noted that the functions, acts, and/or operations specified in the flow charts, sequence diagrams, and/or block diagrams may be re-ordered, processed serially, and/or processed concurrently consistent with embodiments of the invention. Moreover, any of the flow charts, sequence diagrams, and/or block diagrams may include more or fewer blocks than those illustrated consistent with embodiments of the invention.

While embodiments of the invention have been illustrated by a description of various examples, and while these embodiments have been described in considerable detail, it is not the intent of the applicant to restrict or in any way limit the scope of the appended claims to such detail.

In particular, although the invention has particular advantages in embodiments using OFDM modulation, the invention also applies to other type of single-carrier and multi-carrier modulation.

Additional advantages and modifications will readily appear to those skilled in the art. The invention in its broader aspects is therefore not limited to the specific details, representative methods, and illustrative examples shown and described.

## Claims

1. A transmitter device (1) for transmitting a digital input message corresponding to payload data through a communication channel (3), said payload data comprising $B1$ payload bits, the transmitter device comprising a set of transmit antennas, the transmitter device comprising:

   - a waveform generator (10) configured to determine a transmission waveform in $N$ dimensions from said $B1$ payload bits, the transmission waveform being represented by a signal vector s comprising $L$ components $s_l(m)$ ($l = 0, 1,...,L$);
   - an outer code generator (11) configured to generate an outer code $x_n$ ($n = 0, 1, ..., N_{reps}$) from additional B2 bits, the outer code being represented by a vector $x_n$ comprising $N_{reps}$ components;
   - a repetition unit (12) configured to spread the information contained in said waveform s across $N_{reps}$ time slots;
   - a combining unit (14) configured to combine said waveform s with said outer code sequence $x_n$, which provides a combined signal $x_n s_l$, the components of the outer code $x_n$ modulating the waveform coming from at least a part of a time slot;

   the transmitter device being configured to transmit said combined signal in a particular repetition $n$ over the communication channel using said transmit antennas.

2. The transmitter device of claim 1, wherein the waveform generator (10) is configured to use a single carrier or multi-carrier modulation providing modulation symbols grouped into resource blocks, each resource block comprising a number of subcarriers and covering one slot in a time frame, each symbol comprising a number of resource elements, with one resource element per frequency subcarrier, each resource element corresponding to a modulation symbol, the waveform comprising said modulation symbols $s_l$, $L$ being the number of modulation symbols used for the waveform.

3. The transmitter device of any preceding claim 1 and 2, wherein the payload data correspond to:

- uplink control channels, or
- downlink control channels, or
- traffic data channels while the $B2$ bits are used to embed control data.

4. The transmitter device of any preceding claim, wherein the number $B1$ of bits conveyed by the waveform signal and the number of $B2$ bits are chosen to minimize the overall error probability.

5. The transmitter device of any preceding claim, wherein the code sequence generator (12) is configured to generate an outer code sequence $x_n$, $n = 0, 1,..., N_{reps}$ in $N_{reps}$ dimensions which is optimal for non-coherent reception.

6. The transmitter device of any preceding claim, wherein the outer code $x_n$, with $n = 0, 1,..., N_{reps}$, comprises $2^{B2} \times N_{reps}$ code sequences $x_{m,n}$ with $m = 0,1,....,2^{B2} - 1$ and $n = 0,1, ..., N_{reps} - 1$.

7. The transmitter device of claim 6, wherein the code generated by the outer code generator (11) is such that a metric $\rho(m, m')$ determined from pairwise correlations between transmitted vectors $x_{m,n}$ and $x^{*}_{m',n}$ is as close as possible to zero for all $(m,m')$, with $\rho(m, m')$ being defined by:

$$\rho(m, m') = \left| \sum_{n=0}^{N_{reps}-1} x_{m,n} x^{*}_{m',n} \right|$$

8. The transmitter device of any preceding, wherein if $2^{B2} < N_{reps}$, the outer code generator (11) is configured to generate the outer code as an orthogonal code.

9. The transmitter device of claim 8, wherein the code generated by the outer code generator (11) is any row or column of a complex or real $N_{reps} \times N_{reps}$ Hadamard matrix.

10. The transmitter device of any preceding claim 1 to 7, wherein if $2^{B2} \geq N_{reps}$, the outer code generator (11) is configured to generate said outer code as a non-coherent code using a generator matrix $G(N_{reps}, B2)$, from a $(B2, N_{reps})$ linear error correcting code, having a length B2 and a rank $N_{reps}$.

11. The transmitter device (1) of any preceding claim, wherein the outer code generator (11) is configured to apply a permutation operation to the $B1$ bits prior to generate the outer code.

12. The transmitter device of any preceding claim, wherein the repetition unit (12) configured to generate a number $N_{reps}$ of replicas of the waveform signal $s_l(m)$ in time, from at least a part of the waveform signal $s_l(m)$ and the B2 bits of overlay information, the generated replicas $S_r$, with $r = 0,1,...,N_{reps}$ being transmitted in separate time slots.

13. The transmitter device of claim 12, wherein said separate time slots comprise the same number of dimensions as the waveform signal.

14. The transmitter device of any preceding claim, wherein the combining unit (14) is configured to take the $N_{reps}$ replicas $S_r$, and to multiply each dimension of the replicas by a complex scalar corresponding to one component $x_n$, $n = 0,1, ..., N_{reps}$ of the outer code, the $n$ - $th$ combined replica being $x_n S_r$.

15. A method for transmitting a digital input message corresponding to payload data through a communication channel (3), said payload data comprising $B1$ payload bits, the method comprising:

- determining a transmission waveform in $N$ dimensions from said $B1$ payload bits, the transmission waveform being represented by a signal vector s comprising $L$ components $s_l(m)$ ($l = 0, 1, ..., L$);
- generating an outer code $x_n$ ($n = 0, 1,..., N_{reps}$) from additional $B2$ bits, the outer code being represented by a vector $x_n$ comprising $N_{reps}$ components;
- spreading the information contained in said waveform s across $N_{reps}$ time slots;
- combining said waveform s with said outer code sequence $x_n$, which provides a combined signal $x_n s_l$, the

components of the outer code $x_n$ modulating the waveform coming from at least a part of a time slot;

the method comprising transmitting said combined signal in a particular repetition $n$ over the communication channel using transmit antennas.

**10**

```
   1              3              5
```

| Transmitter | → | Transmission channel | → | Receiver |

**FIGURE 1**

**1**

B1 payload bits → **Waveform generator** (10) → $s$ → **Repetition unit** (12) → $S_r$ → **Combining unit** (14) → $x_n S_r$

B2 payload bits → (into Combining unit)

**Outer code generator** (11) → $x_n$, n=1, ..., $N_{rep}$ (into Combining unit)

**FIGURE 2**

<u>30</u>

301                 302                303

| Calculation Unit | Metric determination Unit | Selection unit |
|---|---|---|

**FIGURE 3**

**FIGURE 4**

Generating a waveform $s$ from the payload data $B1$ ⟵ ⌐500

$$s_l, l = 0, 1, \ldots, L - 1$$ ⌐501

Generating an outer code ⟵

$$x_n, n = 0, 1, \ldots, N_{rep}$$ 502

Generating replicates $S_r$ ⟵

$$S_r$$ 504

Combining $S_r$ and $x_n$ ⟵

$$x_n \, S_r$$ 506

Transmitting $x_n \, S_r$ in the repetition n ⟵

**FIGURE 5**

Europäisches
Patentamt

European
Patent Office

Office européen
des brevets

## EUROPEAN SEARCH REPORT

Application Number

EP 21 30 6923

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | QUALCOMM INCORPORATED: "Potential coverage enhancement techniques for PUCCH", 3GPP DRAFT; R1-2009802, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG1, no. e-Meeting; 20201026 - 20201113 17 November 2020 (2020-11-17), XP051955627, Retrieved from the Internet: URL:https://ftp.3gpp.org/tsg_ran/WG1_RL1/TSGR1_103-e/Docs/R1-2009802.zip R1-2009802/R1-2009802 Potential coverage enhancement techniques for PUCCH.docx [retrieved on 2020-11-17] * paragraph [02.2] * ----- | 1-15 | INV. H04L27/26 H04L1/08 H04L5/00 |
| A | WO 2015/170301 A1 (ERICSSON TELEFON AB L M [SE]) 12 November 2015 (2015-11-12) * page 3, line 28 - line 30 * * page 4, line 3 - line 4 * * page 4, line 11 - line 12 * * page 4, line 31 - page 5, line 12 * ----- | 1-15 | TECHNICAL FIELDS SEARCHED (IPC) H04L |

The present search report has been drawn up for all claims

| Place of search | Date of completion of the search | Examiner |
|---|---|---|
| Berlin | 9 June 2022 | Douglas, Ian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
........................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 30 6923

This annex lists the patent family members relating to the patent documents cited in the above-mentioned European search report.
The members are as contained in the European Patent Office EDP file on
The European Patent Office is in no way liable for these particulars which are merely given for the purpose of information.

09-06-2022

| Patent document cited in search report | Publication date | Patent family member(s) | Publication date |
|---|---|---|---|
| WO 2015170301 A1 | 12-11-2015 | EP 3140914 A1<br>US 2015326308 A1<br>WO 2015170301 A1 | 15-03-2017<br>12-11-2015<br>12-11-2015 |

EPO FORM P0459

For more details about this annex : see Official Journal of the European Patent Office, No. 12/82

**REFERENCES CITED IN THE DESCRIPTION**

**Patent documents cited in the description**

- US 8315185 B2

- EP 20305929

**Non-patent literature cited in the description**

- **GABI SARKIS ; PASCAL GIARD ; ALEXANDER VARDY ; CLAUDE THIBEAULT ; WARREN J. GROSS.** Fast List Decoders for Polar Codes. *IEEE Journal on Selected Areas in Communications,* February 2016, vol. 34 (2